# EUROPEAN PATENT APPLICATION

(11) **EP 3 203 010 A1**
(43) Date of publication of application: **09.08.2017**
(21) Application number: 16153832.7
(22) Date of filing: 02.02.2016
(51) Int. Cl.: E21B 33/037, H05K 7/14

(54) **SUBSEA CONTAINER AND METHOD OF MANUFACTURING THE SAME**

(71) Applicant: Siemens Aktiengesellschaft, 80333 München (DE)
(72) Inventor: Skarboe, Roger, 7018 Trondheim (NO)

(57) **Abstract**

There is described a subsea container for housing an electronic module, the subsea container comprising (a) a main body (12, 14) having an opening, (b) a module frame (20, 120) for receiving an electronic module that is to be arranged inside the main body, (c) a support structure for supporting the module frame within the main body, and (d) a lid (16) fitting the opening of the main body, wherein the support structure comprises a shock absorbing structure. Further, a method of manufacturing a subsea container is described.

## Description

### Field of Invention

The present invention relates to the field of subsea devices, in particular subsea containers for electronic equipment.

### Art Background

In subsea installations, such as installations for oil or gas production, various electric and electronic installations need to be placed at the bottom of the sea. This is often done by arranging the installations in subsea containers or canisters, which typically consist of a metal cylinder with a single opening closed by a lid. The electronics are typically mounted in a rack or similar module structure which is fastened on the inner side of the lid, e.g. by means of screws. Although these containers provide good protection against the sea water, they are in some cases susceptible to shock and vibration. More specifically, significant bending forces may impact the electronics causing wear and potential damage.

Therefore, a need exists for an improved subsea container which is capable of providing excellent protection at a reasonable price.

### Summary of the Invention

This need may be met by the subject matter according to the independent claims. Advantageous embodiments of the present invention are described by the dependent claims.

According to a first aspect of the invention there is provided a subsea container for housing an electronic module. The subsea container comprises (a) a main body having an opening, (b) a module frame for receiving an electronic module that is to be arranged inside the main body, (c) a support structure for supporting the module frame within the main body, and (d) a lid fitting the opening of the main body, wherein the support structure comprises a shock absorbing structure.

This aspect of the invention is based on the idea that the module frame (i.e. a part on or in which the electronic module can be mounted, also referred to as a rack) is supported by a shock absorbing structure, such that the impact on the module frame caused by shock and vibration applied to the subsea container, in particular to the main body and/or to the lid (e.g. while bringing the container in place on the bottom of the sea or later on due to stream etc.) is attenuated significantly. Thereby, wear, damage and malfunction of the electronic module caused by vibration or shock can be reduced significantly or even prevented.

The main body and the lid form the actual container, i.e. the outer wall that protects the electronic module against sea water, and are made from a suitable material that is capable of withstanding salt water, such as metal. The wall thickness is generally chosen in dependency of the inner volume of the container and the outside pressure at the place of use, such as on the bottom of the ocean, e.g. at 2 km or more below sea level. Typically, the wall thickness may be between 1 cm and 5 cm, such as between 2 and 4 cm, such as around 3 cm. However, other values are possible. The opening in the main body serves to allow insertion of the module frame containing the relevant electronic module before the lid is mounted to close the container. The support structure serves to keep the module frame (and thereby the electronic module) in place inside the subsea container.

In the present context, the term "electronic module" may in particular denote an assembly of any number of electronic components, such as resistors, inductors, capacitors, diodes, transistors, logic chips, microprocessors, transformers, etc., e.g. arranged on one or more PCBs, and designed to perform one or more specific functions, such as control of subsea equipment or measurement. As such, an electronic module may consist of several sub-modules.

According to an embodiment of the invention, the shock absorbing structure is arranged on an inner wall of the main body.

In other words, the shock absorbing structure (as part of the support structure) is arranged such that it is located between the wall of the main body and the module frame. Thereby, the shock absorbing structure can effectively dampen or attenuate the impact on the module frame that occurs when the container receives sudden blows or when the container is exposed to sudden movements or vibrations.

According to a further embodiment of the invention, the shock absorbing structure comprises a plurality of shock absorbing units.

The shock absorbing units are preferably distributed over the inner surface of the main body and are furthermore connected to (e.g. by screws) or at least in contact with the module frame.

According to a further embodiment of the invention, the shock absorbing units are arranged on a curve, such as a circle, surrounding the module frame.

In other words, the shock absorbing units are arranged on a curve or line that form a closed loop around the module frame. Thereby, the shock absorbing units provide support and shock absorption around the module frame at a particular axial position of the module frame. Depending e.g. on whether an even or uneven number of shock absorbing units are used, the support and shock absorption may be provided in a symmetrical or asymmetrical manner.

According to a further embodiment of the invention, a first part of the shock absorbing units are arranged on a first curve, such as a first circle, surrounding the module frame and a second part of the shock absorbing units are arranged on a second curve, such as a second circle, surrounding the module frame.

In other words, the shock absorbing units are arranged in two separate groups, such that each group forms a closed loop around the module frame. For example, the first part or group of shock absorbing units may be arranged at a predetermined distance from the second part or group of shock absorbing units in the direction of a longitudinal axis of the module frame. Thereby, further the support and shock absorbing effects can be further improved and other means (such as screws) for fastening the module frame may to some extent be dispensed with.

According to a further embodiment of the invention, the shock absorbing units comprise a material, such as rubber, having a Shore A hardness between 50 and 80, such as between 55 and 75, such as between 60 and 70, such as around 65.

Such shock absorbing units are readily available, reasonably priced and easy to use. Furthermore, experiments have shown that a shock absorbing structure using such shock absorbing units has excellent properties and characteristics. In particular, a support structure comprising such shock absorbing structure does not show any strong resonances (with amplification larger than five) at frequencies below 150 Hz and therefore provide excellent support and shock absorption in subsea applications.

According to a further embodiment of the invention, the main body has a cylindrical shape, in particular circular cylindrical, rectangular cylindrical or quadratic cylindrical, although other cylindrical shapes are also possible and encompassed by the present disclosure.

According to a further embodiment of the invention, the support structure further comprises a plurality of screws for securing the module frame to the shock absorbing structure and/or to the lid and/or to the main body.

As additional support, screws may be used to secure the module frame at various locations within the container. The screws may serve to fasten the module frame to one or more of the shock absorbing structure, the lid and the main body in order to further increase the stability of the support structure.

According to a further embodiment of the invention, the support structure further comprises one or more guiding elements for guiding the module frame within the main body.

In particular, the guiding means may be implemented as recesses or protrusions which are shaped to mate with corresponding protrusions or recesses formed in the module frame. Thereby, insertion of the module frame into the main body is facilitated.

According to a further embodiment of the invention, the module frame comprises a protruding element and the lid comprises a recess adapted to receive the protruding element.

To further increase the stability of the module frame when arranged in the subsea container, the lid may according to this embodiment have a recess mating a protruding element of the module frame. Thus, when the lid is arranged to close the opening of the main body after insertion of the module frame (with the electronic module), the protrusion fits into the recess and increased stability and support is provided.

It goes without saying that the same effect may be obtained by providing the protruding element in the lid and providing the recess in the module frame.

According to a second aspect of the invention there is provided a subsea system comprising (a) at least one subsea container according to the first aspect or any the preceding embodiments, (b) a subsea network, and (c) at least one subsea production unit, wherein the at least one subsea container houses an electronic module which is in communication with the at least one subsea production unit via the subsea network.

This aspect of the invention relies on the above described features and advantages of the subsea container according to the present invention to provide an improved subsea system with increased durability and shock resistance.

According to a third aspect of the invention there is provided a method of manufacturing a subsea container for housing an electronic module. The method comprises (a) providing a main body having an opening, (b) providing a module frame for receiving an electronic module that is to be arranged inside the main body, (c) providing a support structure for supporting the module frame within the main body, and (d) providing a lid fitting the opening of the main body, wherein the support structure comprises a shock absorbing structure.

This aspect of the invention is based on the same idea as the first and second aspects described above, namely that of reducing wear, damage and malfunction of electronic modules arranged within subsea containers by utilizing a shock absorbing support structure to support a module frame within the main body of the subsea container.

It is noted that embodiments of the invention have been described with reference to different subject matters. In particular, some embodiments have been described with reference to method type claims whereas other embodiments have been described with reference to apparatus type claims. However, a person skilled in the art will gather from the above and the following description that, unless otherwise indicated, in addition to any combination of features belonging to one type of subject matter also any combination of features relating to different subject matters, in particular to combinations of features of the method type claims and features of the apparatus type claims, is part of the disclosure of this document.

The aspects defined above and further aspects of the present invention are apparent from the examples of embodiments to be described hereinafter and are explained with reference to the examples of embodiments. The invention will be described in more detail hereinafter with reference to examples of embodiments. However, it is explicitly noted that the invention is not limited to the described exemplary embodiments.

### Brief Description of the Drawing

Figure 1 shows a side view of a subsea container according to an exemplary embodiment of the present invention.
Figure 2 shows a side cross-sectional view of the subsea container shown in Figure 1.
Figure 3 shows an end cross-sectional view of the subsea container shown in Figures 1 and 2.
Figure 4 shows an end cross-sectional view of a subsea container according to a further exemplary embodiment of the present invention.

### Detailed Description

The illustration in the drawing is schematic. It is noted that, in different figures, similar or identical elements are provided with the same reference numerals or with reference numerals which differ only within the first digit.

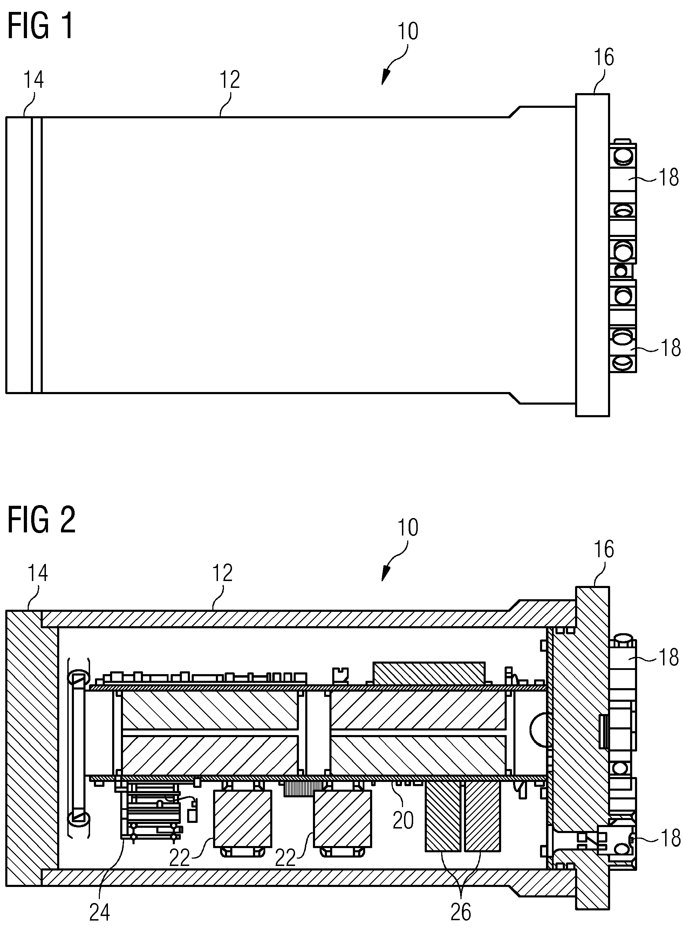

Figure 1 shows a side external view of a subsea container 10 according to an exemplary embodiment of the present invention. As shown, the subsea container 10 generally has an elongate shape and comprises a cylindrical portion 12, an end portion 14 that closes the cylindrical portion 12 at one end, a lid 16 and penetrator/back shell 18. The penetrator/back shell 18 allows cables and wires to extend through the lid 16. The cylindrical portion 12 and the end portion 14 form a main body of the subsea container 10. The lid fits the opening at the end of the cylindrical portion 12 that is opposite to the end portion 14 and is fastened to the main body by screws or bolts (not shown) such that the subsea container is completely sealed. Depending on the specific application, the subsea container 10 has a length (horizontal direction in Figure 1) between 0.5m and 1.5m, such as around 1m. The diameter of the cylindrical portion is typically about half the length, i.e. around 0.5m. Cylindrical portion 12, end portion 14 and lid 16 are all made of salt water resistant material, such as steel. The parts forming the walls of subsea container 10, i.e. cylindrical portion 12, end portion 14, and lid 16 are sufficiently thick to withstand the high pressure at depths of several kilometers below sea level, typically between 1cm and 5cm thick.

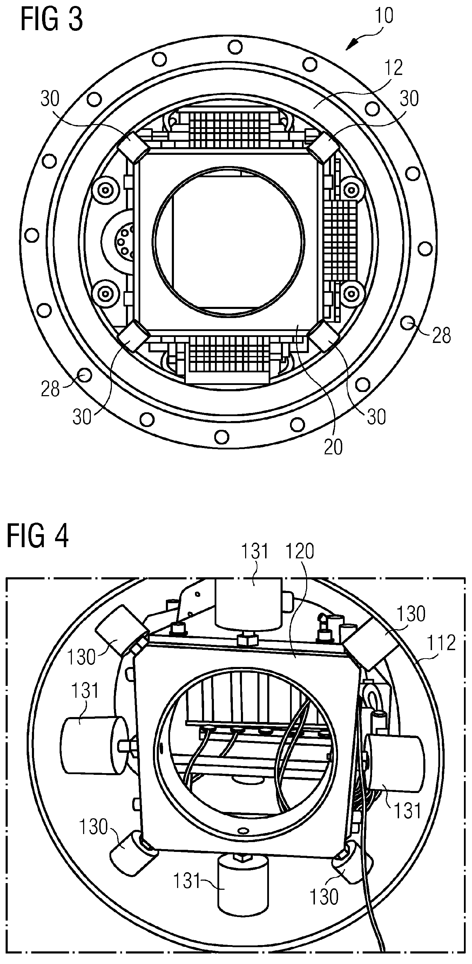

Figure 2 shows a side cross-sectional view of the subsea container 10 shown in Figure 1. Apart from the parts already discussed above in conjunction with Figure 1, Figure 2 shows a module frame 20 arranged inside the cylindrical portion 12 of the subsea container 10. The module frame 20 is a stable (e.g. metallic) frame for carrying electric and electronic components 22, 24, 26 which together form an electronic module. The module frame 20 is supported within the subsea container 10 by a support structure which will be discussed in detail further below with reference to Figure 3 and Figure 4.

Figure 3 shows an end cross-sectional view of the subsea container 10 shown in Figures 1 and 2 and discussed above. More specifically, Figure 3 shows the subsea container 10 without the lid 16. The holes 28 on the outer perimeter of the end face of the cylindrical portion 12 allow fastening the lid 16 with bolts and nuts (not shown). As noted above, the module frame 20 is supported within the subsea container 10 by a support structure. As shown in Figure 3, the support structure comprises four shock absorbing units 30 which are evenly distributed along a circle on the inner wall of the cylindrical portion 12. More specifically, the shock absorbing units 30 are arranged such that each unit 30 is connected (e.g. screw mounted) to a corner portion of the essentially square-shaped module frame 20. The shock absorbing units 30 preferably comprise hard rubber or similar material with a Shore A hardness around 60.

The support structure may contain further shock absorbing units (not shown) arranged deeper within the subsea container 20. Furthermore, the support structure may also contain further support and/or fastening elements (not shown), such as screws, nuts, mating protrusions and recesses, etc.

In sum, the support structure in the subsea container according to the embodiment illustrated in Figures 1 to 3 and discussed above provide effective dampening of shocks and vibrations and does not show any notable resonance phenomena at frequencies below 150 Hz. Thereby, wear of the electronic components and modules carried by the module frame 20 is significantly reduced, which in turn leads to reduced risk of damage as well as extended lifetime of the electronic module.

Figure 4 shows an end cross-sectional view of a subsea container according to a further exemplary embodiment of the present invention. It is noted that the overall structure of the subsea container corresponds to that described above in conjunction with Figures 1 to 3. However, the embodiment shown in Figure 4 differs in the support structure comprising four shock absorbing units 130 arranged between the inner wall of the cylindrical portion 112 and corner portions of the module frame 120 (similar to the arrangement shown in Figure 3) and an additional four shock absorbing units 131 arranged between the inner wall of the cylindrical portion 112 and side portions of the module frame 120. By adding the additional shock absorbing units 131 between the four shock absorbing units 130, the dampening is further improved. As shown, the additional shock absorbing units 131 are larger (both longer and wider) than the shock absorbing units 130.

It is noted that the term "comprising" does not exclude other elements or steps and the use of the articles "a" or "an" does not exclude a plurality. Also elements described in association with different embodiments may be combined. It is further noted that reference signs in the claims are not to be construed as limiting the scope of the claims.

## Claims

1. A subsea container for housing an electronic module, the subsea container comprising
a main body (12, 14) having an opening,
a module frame (20, 120) for receiving an electronic module that is to be arranged inside the main body,
a support structure for supporting the module frame within the main body, and
a lid (16) fitting the opening of the main body, wherein the support structure comprises a shock absorbing structure.

2. The subsea container according to the preceding claim, wherein the shock absorbing structure is arranged on an inner wall of the main body.

3. The subsea container according to any of the preceding claims, wherein the shock absorbing structure comprises a plurality of shock absorbing units (30, 130, 131).

4. The subsea container according to the preceding claim, wherein the shock absorbing units are arranged on a curve surrounding the module frame.

5. The subsea container according to claim 3, wherein a first part of the shock absorbing units are arranged on a first curve surrounding the module frame and a second part of the shock absorbing units are arranged on a second curve surrounding the module frame.

6. The subsea container according to any of claims 3 to 5, wherein the shock absorbing units comprise a material having a Shore A hardness between 50 and 80.

7. The subsea container according to any of the preceding claims, wherein the main body has a cylindrical shape.

8. The subsea container according to any of the preceding claims, wherein the support structure further comprises a plurality of screws for securing the module frame to the shock absorbing structure and/or to the lid and/or to the main body.

9. The subsea container according to any of the preceding claims, wherein the support structure further comprises one or more guiding elements for guiding the module frame within the main body.

10. The subsea container according to any of the preceding claims, wherein the module frame comprises a protruding element and wherein the lid comprises a recess adapted to receive the protruding element.

11. A subsea system comprising
at least one subsea container according to any of the preceding claims,
a subsea network, and
at least one subsea production unit, wherein the at least one subsea container houses an electronic module which is in communication with the at least one subsea production unit via the subsea network.

12. A method of manufacturing a subsea container for housing an electronic module, the method comprising
providing a main body having an opening,
providing a module frame for receiving an electronic module that is to be arranged inside the main body,
providing a support structure for supporting the module frame within the main body, and
providing a lid fitting the opening of the main body, wherein the support structure comprises a shock absorbing structure.
